Europäisches Patentamt

European Patent Office

Office européen des brevets

(11) Publication number: **0 330 749**
**A1**

(12) **EUROPEAN PATENT APPLICATION**

(21) Application number: **88120623.9**

(22) Date of filing: **09.12.88**

(51) Int. Cl.⁴: **H01L 23/50 , H01L 23/30**

The title of the invention has been amended (Guidelines for Examination in the EPO, A-III, 7.3).

(30) Priority: **11.12.87 JP 313672/87**

(43) Date of publication of application:
**06.09.89 Bulletin 89/36**

(84) Designated Contracting States:
**DE FR GB IT**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Ichikawa, Keiji**
**1454-4, Imajuku-Higashi-Cho Asahi-ku**
**Yokohama-shi Kanagawa-ken(JP)**
Inventor: **Ohno, Jun-ichi**
**1-24-24, Nagata-Higashi Minami-ku**
**Yokohama-shi Kanagawa-ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Semiconductor device.**

(57) A semiconductor device comprises an insulating sheet (2) arranged on a pellet mounting portion of a lead frame so as to adhesively fix inner lead tip portions substantially radially arranged around the pellet mounting portion and a semiconductor pellet (3) mounted on the insulating sheet, wherein the insulating sheet is provided on inner leads and is formed so that the peripheral portion (2a) of the insulating sheet is thicker than the central portion thereof.

FIG. 4

# SEMICONDUCTOR DEVICE

## BACKGROUND OF THE INVENTION

This invention relates to a semiconductor device, and more particularly to a semiconductor device of plastic mold type.

Because semiconductor devices of plastic mold type are easy to be mass-produced and can be manufactured at a low cost, they have been widely used. In this connection, they have been also used for large semiconductor devices having many pins of 100 pins or more.

Conventional semiconductor devices of the plastic mold type use a lead frame to provide an arrangement such that a pellet is mounted on the bed portion provided in the central portion, that electrodes on the pellet and inner leads arranged around the bed portion are connected by means of metal wires, and that the entirety is plastic molded.

In such conventional semiconductor devices using lead frames, because of the necessity of the bed portion for mounting the pellet thereon, a tie bar for fixing the bed to the lead frame portion is required. Thus, inner leads can be only arranged in a reduced area obtained by subtracting the area occupied by the tie bar from the original area. Moreover, since the tie bar is protruded from the side surface of the package after being molded in the conventional semiconductor device using a lead frame, it is likely that moisture will penetrate from the outside and will reach the semiconductor pellet. A further problem is that a defect, e.g., crack, etc. based on the difference between coefficient of thermal expansion of the bed portion and that of the molding resin is likely to occur.

For solving such problems, a semiconductor device using a bedless lead frame is conventionally proposed.

An example of the semiconductor device of the bedless type is shown in the Japanese Patent Laid-Open Publication No. 106158/85 wherein an insulating sheet is supported by leads, thus to mount a pellet on the sheet.

However, the problem with such a semiconductor device is that the wire is likely to hang down to produce a short-circuit because it comes into contact with the pellet, resulting in lowered reliability.

## SUMMARY OF THE INVENTION

An object of this invention is to provide a semiconductor device of the bedless type, which is capable of effectively preventing short-circuit due to hanging down of the wire.

In accordance with this invention, there is provided a semiconductor device comprising an insulating sheet arranged on a pellet mounting portion of a lead frame so as to adhesively fix inner lead tip portions substantially radially arranged around the pellet mounting portion and a semiconductor pellet mounted on the insulating sheet, the insulating sheet being provided on the inner leads and being formed so that the peripheral portion thereof is thicker than the central portion thereof.

Since the peripheral portion of the insulating sheet on which the pellet is mounted is rising, even if the wire hangs down, it only comes into contact with the insulating sheet, but does not come into contact with the pellet. Accordingly, this can effectively prevent short-circuit, resulting in an improved high reliability.

## BRIEF DESCRIPTION OF THE DRAWINGS

In the accompanying drawings:

FIG. 1 is a cross sectional view showing an example of a conventional semiconductor device using a lead frame of the bedless type ;

FIG. 2 is an explanatory view showing how wire bonding is conducted using a lead frame on which a bed exists;

FIG. 3 is a cross sectional view showing the problem with the structure shown in FIG. 1;

FIG. 4 is a cross sectional view showing an embodiment of a semiconductor device according to this invention;

FIG. 5 is a perspective view showing the manner of wire-bonding in the semiconductor device shown in FIG. 4; and

FIGS. 6A, 6B, 6C and 6D are perspective views showing various examples of the technique for thickening the peripheral portion of the insulating sheet.

## DESCRIPTION OF THE PREFERRED EMBODIMENT

Prior to the description of an embodiment according to this invention, the problems with the prior art will be explained in detail.

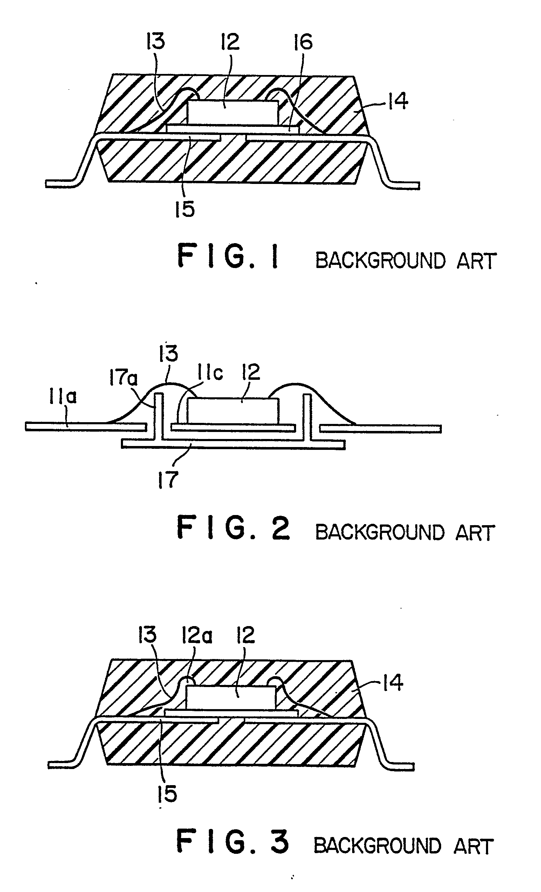

FIG. 1 shows a cross sectional structure of a conventional semiconductor device of the bedless type.

In this structure, leads 15 extend up to the portion in the vicinity of the central portion of the semiconductor device wherein no bed portion is provided. An insulating sheet 16 is fixed substantially in the central portion of the semiconductor device so that it is supported by the leads 15. After a pellet 12 is subjected to die-bonding so that it is mounted on the insulating sheet 16, wire-bonding is conducted to connect the pellet 12 and the leads 15 by means of wires 13.

FIG. 2 shows the wire-bonding in the case of using a conventional lead frame. For the purposes of preventing the wires from hanging down and of improving bondability, a heater 17 provided with projections 17a inserted into gaps between the bed portion 11c and respective inner leads 11a is used. An employment of such a structure eliminates the possibility that the wires 13 hang down below the top of the projection 17a to come into contact with the pellet 12. However, since such a heater provided with projection cannot be used in the semiconductor device of the bedless type shown in FIG. 1, the wire may hang down due to loosening or deformation thereof at the time of wire-bonding as shown in FIG. 3, so that wire 13 comes into contact with the corner portion 12a of the pellet 12, resulting in occurrence of short circuit. In addition, since the potential of the silicon substrate of the pellet of CMOS structure is maintained at $V_{DD}$ in the case of using p-well and at $V_{SS}$ in the case of using n-well, an erroneous operation is produced by contacting the wire to the substrate.

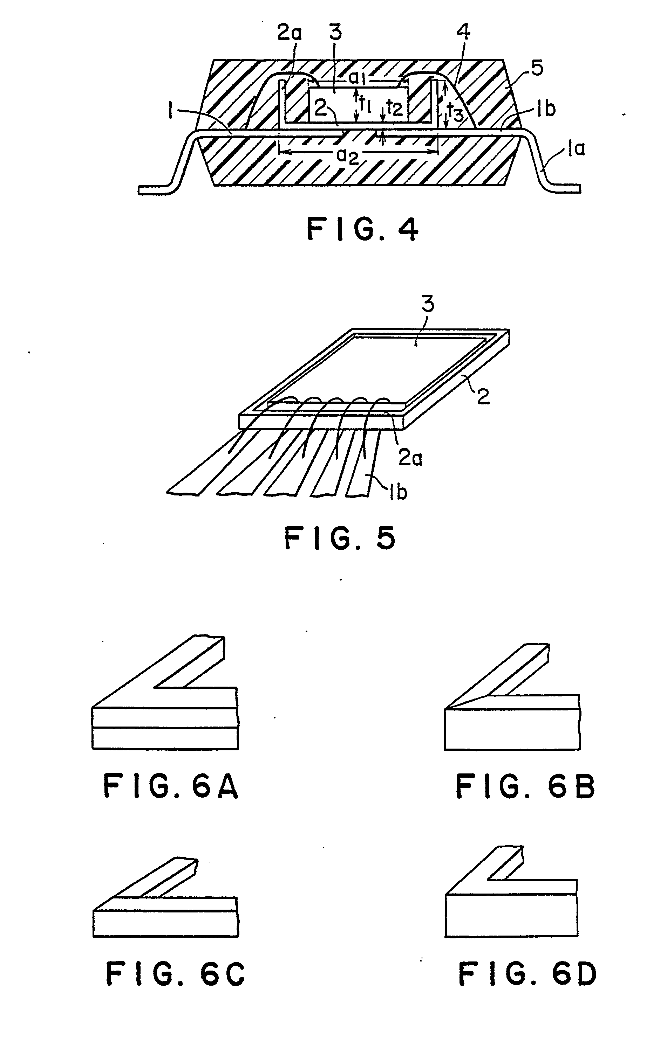

FIG. 4 is a cross sectional view showing a semiconductor device according to an embodiment of this invention.

As seen from this figure, in the same manner as in the conventional bedless type semiconductor device shown in FIG. 1, leads 1 extend up to the portion in the vicinity of the central portion of the semiconductor device wherein no bed portion is provided. An insulating sheet 2 is fixed substantially in the central portion of the semiconductor device so that it is supported by the leads 1. After a pellet 3 is subjected to die-bonding so that it is mounted on the insulating sheet 2, wire-bonding is implemented to connect the pellet 3 and inner leads 1b of the leads 1 by means of wires 4. Under this condition, plastic molding is implemented and leads protruded from the resin portion 5 are processed for downwardly bending as outer leads 1a. Thus, the semiconductor device is completed.

The peripheral portion 2a of the insulating sheet 2 is formed so that it is thicker than the central portion thereof. Namely, as apparent from FIG. 4, the peripheral portion 2a of the insulating sheet is bent upwardly and wires 4 are wired in a manner that they are in contact with the peripheral portion 2a or pass slightly thereabove. It is clearly shown in the perspective view of FIG. 5 that wires pass above the peripheral portion 2a formed thick. FIGS. 6A to 6D show several examples of the thickened peripheral portion of the insulating sheet. FIG. 6A shows the type most widely used wherein a different insulating sheet comprised of only a peripheral portion is adhered onto an ordinary insulating sheet with it overlapping with the latter. FIGS. 6B and 6C show the types in which the peripheral portion is bent. In addition, FIG. 6D shows the type in which the central portion of the thick sheet is subjected to etching with the peripheral portion thereof being left. Similar shapes may be formed by resin molds. The types in FIGS. 6B and 6C are the same only except for the fact that joining conditions of the bent portions are different from each other wherein the joining surface is substantially along the diagonal line of the insulating sheet in FIG. 6B, whereas the joining surface is along the outer peripheral side of the insulating sheet in FIG. 6C.

For such an insulating sheet, a polyimide resin sheet having excellent heat resisting property and moisture resisting property is ordinarily used.

The dimensional relationship between the insulating sheet and the pellet will be now considered. It is desirable for prevention of short-circuit that the height of the insulating sheet peripheral portion be higher than that of the upper surface of the pellet mounted on the insulating sheet. Accordingly, when the thickness of the pellet is assumed as $t_1$, the thickness of the pellet mounting portion of the insulating sheet is assumed as $t_2$, and the thickness of the peripheral portion of the insulating sheet is assumed as $t_3$, it is sufficient to satisfy the following relationship:

$$t_1 + t_2 \leqq t_3.$$

For example, when the length $a_1$ of one side of the pellet is equal to 7 mm and the length $a_2$ of one side of the insulating sheet is equal to 9 mm, a selection such that $t_1 = 0.45$ mm, $t_2 = 0.1$ mm, and $t_3 = 0.6$ mm may be made. At this time, the horizontal distance of the wire from the electrode on the pellet up to the wire bonding position on the lead is about 2.5 mm.

The material of the insulating sheet and the processing for thickening the peripheral portion thereof are not limited to the ones shown in the above-described embodiment, but other materials and methods may be used.

As described above, since the peripheral portion of the insulating sheet mounted and fixed on the leads is formed so that it is thicker than central portion thereof in the semiconductor device according to this invention, even if hanging down of wires due to loosening or deformation thereof occurs at the time of wire-bonding after the pellet is mounted on the central portion of the insulating sheet, there is no possibility that wires and the pellet are in contact with each other, thus making it possible to prevent occurrence of short-circuit to improve the product reliability.

## Claims

1. A semiconductor device comprising an insulating sheet (2) arranged on a pellet mounting portion of a lead frame so as to adhesively fix inner lead tip portions substantially radially arranged around said pellet mounting portion and a semiconductor pellet (3) mounted on said insulating sheet, characterized in that said insulating sheet is provided on the inner leads and is formed so that the peripheral portion (2a) of said insulating sheet is thicker than the central portion thereof.

2. A semiconductor device as set forth in claim 1, wherein said insulating sheet consists of polyimide.

3. A semiconductor device as set forth in claim 1, wherein the sum of the thickness of the central portion of said insulating sheet and the thickness of said pellet is smaller than the thickness of said peripheral portion of said insulating sheet.

4. A semiconductor device as set forth in claim 1, wherein said insulating sheet is formed by allowing a first sheet to overlap with a second sheet comprised of only the peripheral portion of said first sheet.

5. A semiconductor device as set forth in claim 1, wherein said insulating sheet is comprised of a resin molded material in which only the peripheral portion is formed thick.

F I G. 1 BACKGROUND ART

F I G. 2 BACKGROUND ART

F I G. 3 BACKGROUND ART

FIG. 4

FIG. 5

FIG. 6A

FIG. 6B

FIG. 6C

FIG. 6D

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | PATENT ABSTRACTS OF JAPAN, vol. 9, no. 230 (E-343)[1953], 17th September 1985; & JP-A-60 84 854 (TOSHIBA K.K.) 14-05-1985 * Abstract * | 1 | H 01 L 23/50 H 01 L 23/30 |
| A | Idem | 2-5 | |
| Y | PATENT ABSTRACTS OF JAPAN, vol. 9, no. 193 (E-334)[1916], 9th August 1985; & JP-A-60 60 743 (MATSUSHITA DENSHI KOGYO K.K.) 08-04-1985 * Abstract * | 1 | |
| A | EP-A-0 078 606 (TEXAS INSTRUMENTS INC.) * Page 7, lines 22-30; page 8, lines 16-19,24-25; figures 2,3 * | 1,3 | |
| A | PATENT ABSTRACTS OF JAPAN, vol. 5, no. 78 (E-58)[750], 22nd May 1981; & JP-A-56 24 958 (KIYUUSHIYUU NIPPON DENKI K.K.) 10-03-1981 | 1,3 | TECHNICAL FIELDS SEARCHED (Int. Cl.4) H 01 L 23/00 H 01 L 21/00 |

The present search report has been drawn up for all claims

| Place of search | Date of completion of the search | Examiner |
|---|---|---|
| THE HAGUE | 03-07-1989 | DELPORTE B.P.M. |

EPO FORM 1503 03.82 (P0401)